# EUROPEAN PATENT APPLICATION

(11) **EP 3 770 305 A1**
(43) Date of publication of application: **27.01.2021**
(21) Application number: 19772301.8
(22) Date of filing: 19.03.2019
(51) Int. Cl.: C25D 3/32, C25D 3/60, C25D 5/02, C25D 5/50, C25D 7/00, C25D 7/12

(54) **TIN OR TIN-ALLOY PLATING LIQUID, BUMP FORMING METHOD, AND CIRCUIT BOARD PRODUCTION METHOD**

(30) Priority: 20.03.2018 JP 2018052012; 26.03.2018 JP 2018057551; 06.03.2019 JP 2019040216
(71) Applicant: Mitsubishi Materials Corporation, Tokyo 100-8117 (JP)
(72) Inventor: WATANABE Mami, Naka-shi, Ibaraki 311-0102 (JP); SUSUKI Kyoka, Naka-shi, Ibaraki 311-0102 (JP); NAKAYA Kiyotaka, Naka-shi, Ibaraki 311-0102 (JP)
(74) Representative: Gille Hrabal
(86) International application number: PCT/JP2019/011348
(87) International publication number: WO 2019/181905

(57) **Abstract**

This tin or tin-alloy plating liquid contains (A) a soluble salt including at least a stannous salt; (B) an acid selected from an organic acid and an inorganic acid, or a salt thereof; (C) a surfactant; (D) a leveling agent; and (E) an additive, wherein the surfactant is a compound (C1) represented by Formula (1) and/or a compound (C2) represented by Formula (2).

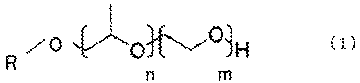

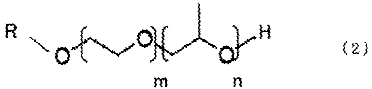

In Formulas (1) and (2), R is an alkyl group having 7 to 13 carbon atoms, m is 5 to 11, n is 1 to 3, and m and n are different from each other.

## Description

### TECHNICAL FIELD

The present invention relates to a tin or tin-alloy plating liquid for producing bumps serving as bump electrodes of tin or a tin alloy on a substrate when mounting a semiconductor integrated circuit chip on a circuit board, a method for forming bumps (a bump forming method) using the same, and a method for producing a circuit board (a circuit board production method). The invention more particularly relates to a tin or tin-alloy plating liquid which has excellent via filling property for vias on a substrate even in a pattern having different bump diameters or bump pitches, and which can form bumps having a uniform height.

The present application claims priority on Japanese Patent Application No. 2018-52012 filed on March 20, 2018, Japanese Patent Application No. 2018-57551 filed on March 26, 2018, and Japanese Patent Application No. 2019-40216 filed on March 6, 2019, the contents of which are incorporated herein by reference.

### BACKGROUND ART

In a circuit board on which a semiconductor integrated circuit chip (hereinafter, referred to as a semiconductor chip) is to be mounted, a chip size/scale package (CSP) type semiconductor device having a package substrate area that is reduced to approximately the same size as that of a semiconductor chip to be mounted on the substrate is currently mainly produced, in order to support lightness, thinness, shortness, and smallness (lightening, thinning, and miniaturization). In order to connect the circuit board and the semiconductor chip to each other, via openings which are via bodies on a substrate side are filled with tin or a tin alloy to form bumps which are bump electrodes of protruding metal terminals, and these bumps are loaded with a semiconductor chip.

In the related art, in a case of forming bumps by the filling of the tin or tin alloy material, the via bodies are filled with a conductive paste such as a tin-based solder paste or tin-based solder balls, or tin-plating deposition layers are formed in the vias by an electroplating method using a tin or tin-alloy plating liquid, and subsequently, the conductive paste, the solder balls, or the tin plating deposition layers are melted by a heat treatment.

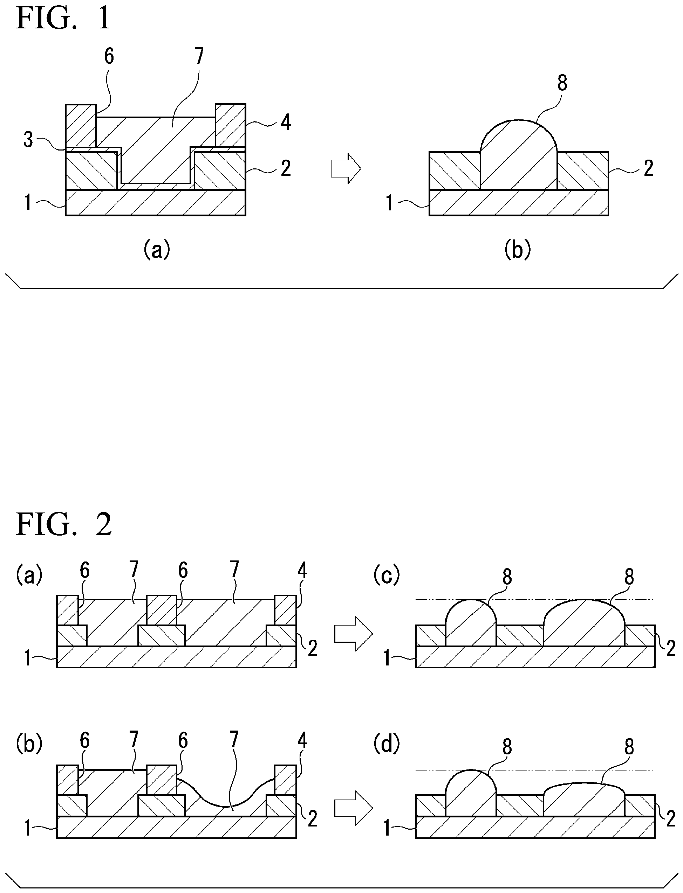

A general method for forming bumps by the electroplating method will be described with reference to FIG. 1. As shown in FIG. 1(a), a solder resist pattern having an opening is formed by lithography using a solder resist, on a surface of a substrate 1 on which wiring or the like is provided. Next, a copper seed layer 3 for supplying electricity is formed on a surface of a solder resist layer 2 by electroless plating. Next, a dry film resist layer 4 is formed on a surface of the copper seed layer 3, and a dry film resist pattern having an opening is formed so as to be connected to the opening of the solder resist layer 2. Next, by supplying electricity through the copper seed layer 3, tin electroplating is performed in a via 6 of the dry film resist pattern, and a tin plating deposition layer 7 (tin plated film) is formed on the copper seed layer 3 in the via 6. Next, the dry film resist layer 4 and the copper seed layer 3 are sequentially removed, and subsequently, the remaining tin plating deposition layer 7 is melted by a reflow process, and a tin bump 8 is formed as shown in FIG. 1(b).

Previously, in a case of forming tin or tin alloy bumps using the electroplating method, the improvement regarding via filling property of vias on the substrate or prevention of voids in the bumps has been made by changing the components included in the tin or tin-alloy plating liquid (for example, see Patent Documents 1, 2, 3, and 4).

Patent Document 1 discloses a tin or tin-alloy plating liquid containing a compound of specific α,β-unsaturated aldehyde or specific α,β-unsaturated ketone. The following matters are described in Patent Document 1.

This plating liquid has high via filling property. When this plating liquid is used, since tin plating is selectively deposited in recesses, a tin plating deposit having substantially no voids is obtained.

Since no tinting or abnormal deposition occurs on a surface of the formed tin plated film, a tin plated film is obtained that is excellent in solderability and discoloration resistance and has a practical and good appearance.

Since this plating liquid has high via filling property, it is possible to form a columnar tin plating deposit (bump) having substantially no voids.

Patent Document 2 discloses a tin or tin-alloy plating liquid including (a) a carboxyl group-containing compound, and (b) a carbonyl group-containing compound, wherein the amount of the component (a) is 1.3 g/L or more, and the amount of the component (b) is 0.3 g/L or more. The following matters are described in Patent Document 2.

By electroplating an object to be plated having blind vias or through holes using this plating liquid, the blind vias or the through holes can be filled with high reliability in a short amount of time.

The plating liquid can be used for three-dimensional mounting of semiconductors, a step of filling blind vias or through holes in a printed wiring board, or a formation of silicon through electrodes.

Patent Document 3 discloses a tin or tin-alloy plating liquid containing inorganic acid, organic acid, and a water-soluble salt thereof, a surfactant, and a leveling agent. The surfactant is at least one nonionic surfactant selected from the group consisting of polyoxyalkylene phenyl ethers or salts thereof and polyoxyalkylene polycyclic phenyl ethers or salts thereof. The phenyl forming the polyoxyalkylene phenyl ether and the polycyclic phenyl forming the polyoxyalkylene polycyclic phenyl ether may be substituted with an alkyl group having 1 to 24 carbon atoms or a hydroxy group. The leveling agent is at least one selected from the group consisting of aliphatic aldehydes, aromatic aldehydes, aliphatic ketones, and aromatic ketones; and α,β-unsaturated carboxylic acids, or amides thereof or salts thereof. The following matters are described in Patent Document 3.

Since a specific nonionic surfactant and two specific leveling agents are contained, recess filling property is excellent and it is possible to suppress the occurrence of voids. As a result, by using this plating liquid, it is possible to provide good bumps that are smooth without recesses and do not generate voids after reflow.

Further, Patent Document 4 discloses a tin or tin-alloy electroplating liquid for forming bump electrodes, containing (A) a soluble salt consisting of either one of a stannous salt or a mixture of a stannous salt and a salt of a metal selected from silver, copper, bismuth, nickel, indium, and gold, (B) acid or a salt thereof, (C) a filling organic compound selected from the group consisting of aromatic and aliphatic aldehydes, aromatic and aliphatic ketones, unsaturated carboxylic acids, and aromatic carboxylic acids, and (D) a nonionic surfactant. The following matters are described in Patent Document 4.

Since in this plating liquid, the component (D) is used in combination with the specific compound (C) that suppresses precipitation of a tin material, it is possible to effectively suppress the deposition on the upper part of the via and to advance the deposition of the tin material from the bottom of the via preferentially toward the upper part of the via. Therefore, it is possible to smoothly fill the via while preventing the occurrence of voids. As a result, the bump electrodes can be favorably formed with or without reflow, and the bonding strength and electrical characteristics are excellent.

In recent years, wiring patterns having different bump diameters or bump pitches have been mixed on one circuit board. In such complicated wiring patterns, it is necessary to form all bumps at a uniform height, even in a case where the bump diameters and the bump pitches are different. According to the tin or tin-alloy plating liquids of Patent Documents 1 to 4, there are advantages that the occurrence of voids in the bumps is prevented, the vias on the substrate can be filled with high reliability in a short period of time, and the via filling property and appearance are excellent. However, the plating liquids for substrates in Patent Documents 1 to 4 do not aim at achieving bump height uniformity.

Specifically, as shown in FIG. 2, in the case of a pattern having different bump diameters, plating with a conventional tin or tin-alloy plating liquid can improve the via filling property of either one of a small diameter or a large diameter, but the via filling property of the other is reduced. That is, in a case of performing the plating on both vias 6 at the same time on a substrate having both vias 6 having a small diameter and a large diameter, it is difficult to perform the plating on both vias 6 with excellent via filling properties. As described above, in a case where vias 6 having different via filling properties are present (FIG. 2(b)), a variation in height of the bumps 8 after the reflow increases, and height uniformity of the bumps 8 cannot be achieved (FIG. 2(d)). Therefore, in order to achieve the height uniformity of the bumps 8 (FIG. 2(c)), as shown in FIG. 2(a), it is necessary to improve via filling properties for both vias 6 having a small diameter and a large diameter.

### PRIOR ART DOCUMENTS

### Patent Document

Patent Document 1: Japanese Unexamined Patent Application, First Publication No. 2014-125662 (claim 2, paragraph [0020])
Patent Document 2: Japanese Unexamined Patent Application, First Publication No. 2015-007276 (claim 1, paragraphs [0011] and [0012])
Patent Document 3: Japanese Unexamined Patent Application, First Publication No. 2015-193916 (claim 1, paragraph [0019])
Patent Document 4: Japanese Unexamined Patent Application, First Publication No. 2016-074963 (claim 1, paragraph [0019])

### DISCLOSURE OF INVENTION

### Problems to be Solved by the Invention

An object of the invention is to provide a tin or tin-alloy plating liquid which has an excellent via filling property for vias on a substrate even in a pattern having different bump diameters, and which can form bumps having a uniform height.

### Solutions for Solving the Problems

A first aspect of the present invention is a tin or tin-alloy plating liquid containing: (A) a soluble salt including at least a stannous salt; (B) an acid selected from an organic acid and an inorganic acid, or a salt thereof; (C) a surfactant; (D) a leveling agent; and (E) an additive, wherein the surfactant is a compound (C1) represented by Formula (1) and/or a compound (C2) represented by Formula (2).

In Formula (1), R is an alkyl group having 7 to 13 carbon atoms, m is 5 to 11, n is 0 to 3, and m and n are different from each other. In addition, in Formula (2), R is an alkyl group having 7 to 13 carbon atoms, m is 5 to 11, n is 1 to 3, and m and n are different from each other.

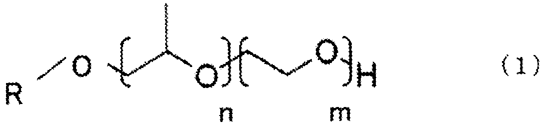

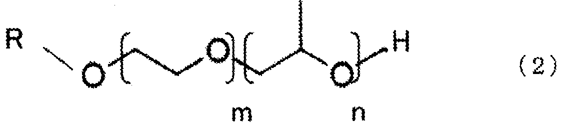

A second aspect of the present invention is the tin or tin-alloy plating liquid according to the first aspect, wherein the additive contains two or more selected from a surfactant other than the two surfactants (C1 and C2), an antioxidant, and an alcohol having 1 to 3 carbon atoms.

A third aspect of the present invention is a method for forming bumps including: a step of forming tin or tin-alloy plating deposition layers on a substrate using the tin or tin-alloy plating liquid according to the first or second aspect; and a step of subsequently performing a reflow process to form bumps.

A fourth aspect of the present invention is a method for producing a circuit board including: producing a circuit board using the bumps formed by the method according to the third aspect.

### Effects of Invention

In the tin or tin-alloy plating liquid according to the first aspect of the present invention, the surfactants (C1 and C2) have specific nonionic structure in which the number n of polyoxypropylene alkyl groups and the number m of polyoxyethylene groups in Formulas (1) and (2) are set to be in the predetermined ranges, respectively. Accordingly, at the time of plating, it is possible to suppress precipitation of Sn ions and perform good plating on a surface to be plated. In particular, according to this plating liquid, in a case of a pattern having different bump diameters, although the bump diameter is large or small, the via filling property for vias on a substrate are excellent, and heights of formed bumps become uniform. It is considered that this is because the polarization resistance increases.

In the tin or tin-alloy plating liquid according to the second aspect of the present invention, two or more selected from a surfactant other than the two surfactants (C1 and C2), an antioxidant, and an alcohol having 1 to 3 carbon atoms are further contained; and thereby, the following effects are exhibited. The surfactant other than the two surfactants (C1 and C2) exhibits effects such as stabilization of the plating liquid, improvement of solubility, and the like. In addition, the antioxidant prevents the oxidation of a soluble stannous salt to a stannic salt. Further, the alcohol exhibits an effect of improving the solubility of the surfactant.

In the method according to the third aspect of the present invention, the tin or tin-alloy plating deposition layers are formed on a substrate using the tin or tin-alloy plating liquid according to the first or second aspect, and next, a reflow process is performed to form bumps. Accordingly, it is possible to form bumps having a uniform height even in a pattern having different bump diameters.

In the method according to the fourth aspect of the present invention, a circuit board is produced using the bumps formed by the method according to the third aspect. Accordingly, a highly reliable semiconductor device without electrical connection failure can be produced.

### BRIEF DESCRIPTION OF DRAWINGS

FIG. 1(a) is a cross-sectional view of a substrate in which a plating deposition layer is formed in a via, according to the present embodiment. FIG. 1(b) is a cross-sectional view of the substrate, after peeling a dry film and a copper seed layer and heating the plating deposition layer.

FIG. 2(a) is a cross-sectional configuration diagram of a substrate showing an example in which plating deposition layers have good via filling property in a pattern having different bump diameters (via diameters). FIG. 2(b) is a cross-sectional configuration diagram of a substrate showing an example in which plating deposition layers have poor via filling property in a pattern having different bump diameters (via diameters). FIG. 2(c) is a cross-sectional configuration diagram of a substrate which is in a state after peeling a dry film and a copper seed layer in FIG. 2(a) and heating the plating deposition layers and shows an example in which heights of formed bumps are uniform. FIG. 2(d) is a cross-sectional configuration diagram of a substrate which is in a state after peeling a dry film and a copper seed layer in FIG. 2(b) and heating the plating deposition layer and shows an example in which heights of formed bumps vary.

### EMBODIMENTS FOR CARRYING OUT THE INVENTION

Next, an embodiment of the present invention will be described.

A tin or tin-alloy plating liquid of the present embodiment contains (A) a soluble salt including at least a stannous salt, (B) an acid selected from an organic acid and an inorganic acid, or a salt thereof, (C) a surfactant, (D) a leveling agent, and (E) an additive. The remainder is water of a solvent. The surfactant is the compound (C1) represented by Formula (1) and/or the compound (C2) represented by Formula (2).

The soluble salt includes either one of a stannous salt or a mixture of the stannous salt and a salt of a metal selected from silver, copper, bismuth, nickel, antimony, indium, and zinc.

The tin alloy of the present embodiment is an alloy of tin and a predetermined metal selected from silver, copper, bismuth, nickel, antimony, indium, and zinc, and examples thereof include a tin-silver alloy, a tin-copper alloy, a tin-bismuth alloy, a tin-nickel alloy, a tin-antimony alloy, a tin-indium alloy, a binary alloy of a tin-zinc alloy, and a ternary alloy such as a tin-copper-bismuth alloy or tin-copper-silver alloy.

Therefore, the soluble salt (A) of the present embodiment means any soluble salt that generates various metal ions such as Sn²⁺, Ag⁺, Cu⁺, Cu²⁺, Bi³⁺, Ni²⁺, Sb³⁺, In³⁺, and Zn²⁺ in the plating liquid, and examples thereof include an oxide and a halide of the metal, and the metal salt of inorganic acid or organic acid.

Examples of the oxide of the metal include a stannous oxide, a copper oxide, a nickel oxide, a bismuth oxide, an antimony oxide, an indium oxide, and a zinc oxide. Examples of the halide of the metal include a stannous chloride, a bismuth chloride, a bismuth bromide, a cuprous chloride, a cupric chloride, a nickel chloride, an antimony chloride, an indium chloride, and a zinc chloride.

Examples of the metal salt of inorganic acid or organic acid include copper sulfate, stannous sulfate, bismuth sulfate, nickel sulfate, antimony sulfate, bismuth nitrate, silver nitrate, a copper nitrate, antimony nitrate, indium nitrate, nickel nitrate, zinc nitrate, copper acetate, nickel acetate, nickel carbonate, sodium stannate, stannous borofluoride, stannous methanesulfonate, silver methanesulfonate, copper methanesulfonate, bismuth methanesulfonate, nickel methanesulfonate, indium methanesulfonate, zinc bis(methanesulfonate), stannous ethanesulfonate, and bismuth 2-hydroxypropanesulfonate.

The acid or the salt thereof (B) of the present embodiment is selected from an organic acid, an inorganic acid, and a salt thereof. Examples of the organic acid include an organic sulfonic acid such as an alkane sulfonic acid, an alkanol sulfonic acid, and an aromatic sulfonic acid, or an aliphatic carboxylic acid. Examples of the inorganic acid include a borofluoric acid, a hydrosilicofluoric acid, a sulfamic acid, a hydrochloric acid, a sulfuric acid, a nitric acid, and a perchloric acid. Examples of the salt thereof include a salt of alkali metal, a salt of alkaline earth metal, an ammonium salt, an amine salt, and a sulfonate. The component (B) is preferably the organic sulfonic acid from a viewpoint of solubility of the metal salt or ease of wastewater treatment.

As the alkanesulfonic acid, a material represented by a chemical formula CₙH₂ₙ₊₁SO₃H (for example, n = 1 to 5, preferably 1 to 3) can be used, and specific examples thereof include methanesulfonic acid, ethanesulfonic acid, 1-propanesulfonic acid, 2-propanesulfonic acid, 1-butanesulfonic acid, 2-butanesulfonic acid, pentanesulfonic acid, hexanesulfonic acid, decanesulfonic acid, and dodecanesulfonic acid.

As the alkanolsulfonic acid, a material represented by a chemical formula CₚH_{2p+ 1}-CH(OH)-C_{q}H_{2q}-SO₃H (for example, p = 0 to 6, q = 1 to 5) can be used, and specific examples thereof include 2-hydroxyethane-1-sulfonic acid, 2-hydroxypropane-1-sulfonic acid, 2-hydroxybutane-1-sulfonic acid, 2-hydroxypentane-1-sulfonic acid, 1-hydroxypropane-2-sulfonic acid, 3-hydroxypropane-1-sulfonic acid, 4-hydroxybutane-1-sulfonic acid, 2-hydroxyhexane-1-sulfonic acid, 2-hydroxydecane-1-sulfonic acid, and 2-hydroxydodecane-1-sulfonic acid.

The aromatic sulfonic acid is basically benzene sulfonic acid, alkyl benzene sulfonic acid, phenol sulfonic acid, naphthalene sulfonic acid, or alkyl naphthalene sulfonic acid, and specific examples thereof include 1-naphthalene sulfonic acid, 2-naphthalene sulfonic acid, toluenesulfonic acid, xylenesulfonic acid, p-phenolsulfonic acid, cresolsulfonic acid, sulfosalicylic acid, nitrobenzenesulfonic acid, sulfobenzoic acid, and diphenylamine-4-sulfonic acid.

Examples of the aliphatic carboxylic acid include acetic acid, propionic acid, butyric acid, citric acid, tartaric acid, gluconic acid, sulfosuccinic acid, and trifluoroacetic acid.

The nonionic surfactant (C1) included as the surfactant (C) of the present embodiment is a condensate of polyoxyethylene and polyoxypropylene alkyl ether or polyoxyethylene alkyl ether, represented by the following Formula (1).

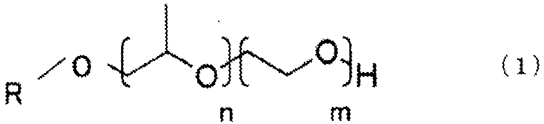

In Formula (1), R is an alkyl group having 7 to 13 carbon atoms, m is 5 to 11, n is 0 to 3, and m and n are different from each other. The alkyl group of R may be linear or may have a branched chain. In a case where the carbon number of R is less than 7, there is a problem that the appearance of plating is abnormal. In a case where the carbon number of R exceeds 13, there is a problem that it is difficult to dissolve in the plating liquid, the via filling property is poor, or the appearance of plating is abnormal. The carbon number of R is preferably 10 to 12. In addition, in a case where m is less than 5, there is a problem that it is difficult to dissolve in the plating liquid or the appearance of plating is abnormal. In a case where m exceeds 11, there is a problem that the via filling property is poor. m is preferably 6 to 10. Further, in a case where n exceeds 3, there is a problem that it is difficult to dissolve in the plating liquid or the appearance of plating is abnormal, n is preferably 0 to 2.

The nonionic surfactant (C2) included as the surfactant (C) of the present embodiment is a condensate of polyoxypropylene and polyoxyethylene alkyl ether, represented by the following Formula (2).

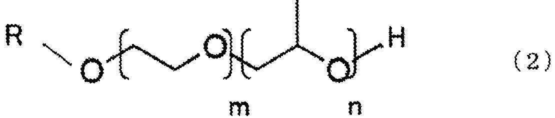

In Formula (2), R is an alkyl group having 7 to 13 carbon atoms, m is 5 to 11, n is 1 to 3, and m and n are different from each other. The alkyl group of R may be linear or may have a branched chain. In a case where the carbon number of R is less than 7, there is a problem that the appearance of plating is abnormal. In a case where the carbon number of R exceeds 13, there is a problem that it is difficult to dissolve in the plating liquid, the via filling property is poor, or the appearance of plating is abnormal. The carbon number of R is preferably 10 to 12. In addition, in a case where m is less than 5, there is a problem that it is difficult to dissolve in the plating liquid or the appearance of plating is abnormal. In a case where m exceeds 11, there is a problem that the via filling property is poor. m is preferably 6 to 10. Further, in a case where n exceeds 3, there is a problem that it is difficult to dissolve in the plating liquid or the appearance of plating is abnormal, n is preferably 1 to 2.

The leveling agent (D) of the present embodiment is added to form a uniform and dense plated film and to smooth the plated film. In order to improve the via filling property and suppress the generation of voids, two kinds of a first leveling agent (D-1) and a second leveling agent (D-2) are used. Examples of the first leveling agent (D-1) include one or more selected from the group consisting of aliphatic aldehyde, aromatic aldehyde, aliphatic ketone, and aromatic ketone, and examples of the second leveling agent (D-2) include α,β-unsaturated carboxylic acid, amides thereof, and salts thereof.

The first leveling agent (D-1) is a carbonyl compound containing aldehyde or ketone, and does not include the α, β-unsaturated carboxylic acid of the second leveling agent (D-2). Specific examples are as follows. Examples of the aliphatic aldehyde include formaldehyde, acetaldehyde, and allyl aldehyde. Examples of the aromatic aldehyde include benzaldehyde, 2-chlorobenzaldehyde, 3-chlorobenzaldehyde, 4-chlorobenzaldehyde, 2,4-dichlorobenzaldehyde, 2,6-dichlorobenzaldehyde, 2,4,6-trichlorobenzaldehyde, 1 -naphthaldehyde, 2-naphthaldehyde, 2-hydroxybenzaldehyde, 3 -hydroxybenzaldehyde, 4-hydroxybenzaldehyde, 2-methylbenzaldehyde, 3-methylbenzaldehyde, 4-methylbenzaldehyde, m-anisaldehyde, o-anisaldehyde, and p-anisaldehyde. In addition, examples of the aliphatic ketone include acetylacetone. Further, examples of the aromatic ketone include benzylideneacetone (synonymous with benzalacetone), 2-chloroacetophenone, 3-chloroacetophenone, 4-chloroacetophenone, 2,4-dichloroacetophenone, and 2,4,6-trichloroacetophenone. One of these may be used alone or a combination of two or more thereof may be used. A preferable amount of the first leveling agent (D-1) in an electroplating bath (an amount of a single substance in a case where it is used alone, and a total amount of substances in a case where two or more kinds are included) is 0.001 g/L to 0.3 g/L and more preferably 0.01 g/L to 0.25 g/L. In a case where the amount of the component is small, the effect of adding the component is not sufficient, and on the other hand, in a case where the amount of the component is excessively large, the smoothing of the plated film may be inhibited.

Examples of the second leveling agent (D-2) include acrylic acid, methacrylic acid, picolinic acid, crotonic acid, 3-chloroacrylic acid, 3,3-dimethylacrylic acid, 2,3-dimethylacrylic acid, methyl acrylate, ethyl acrylate, n-butyl acrylate, isobutyl acrylate, 2-ethylhexyl acrylate, ethyl methacrylate, n-butyl methacrylate, isobutyl methacrylate, 2-hydroxyethyl methacrylate, 2-hydroxypropyl methacrylate, 2-dimethylaminoethyl methacrylate, methacrylic anhydride, and methyl methacrylic acid. In addition, the second leveling agent (D-2) also includes amide of α,β-unsaturated carboxylic acid (for example, acrylamide or the like) and a salt of α,β-unsaturated carboxylic acid (for example, salt of potassium, sodium, or ammonium). A preferable amount of the second leveling agent (D-2) in an electroplating bath (an amount of a single substance in a case where it is used alone, and a total amount of substances in a case where two or more kinds are included) is 0.01 g/L to 50 g/L and more preferably 0.05 g/L to 10 g/L. In a case where the amount of the component is small, the effect of adding the component is not sufficient, and on the other hand, in a case where the amount of the component is excessively large, the smoothing of the plated film may be inhibited.

The additive (E) of the present embodiment is various additives added to the tin or tin-alloy plating liquid. The additive (E) preferably includes two or more selected from a surfactant other than the two surfactants (C1 and C2) described above, an antioxidant, and an alcohol having 1 to 3 carbon atoms.

In this case, examples of the other surfactant include an ordinary anionic surfactant, a cationic surfactant, a nonionic surfactant, and an amphoteric surfactant.

Examples of the anionic surfactant include polyoxyalkylene alkyl ether sulfate such as sodium polyoxyethylene (containing 12 mol of ethylene oxide in 1 mol of molecule) nonyl ether sulfate; polyoxyalkylene alkyl phenyl ether sulfate such as sodium polyoxyethylene (containing 12 mol of ethylene oxide in 1 mol of molecule) dodecylphenyl ether sulfate; alkyl benzene sulfonate such as sodium dodecylbenzene sulfonate; naphthol sulfonate such as sodium 1-naphthol-4-sulfonate or disodium 2-naphthol-3,6-disulfonate; (poly)alkylnaphthalenesulfonate such as sodium diisopropylnaphthalenesulfonate or sodium dibutylnaphthalenesulfonate; and alkyl sulfate such as sodium dodecyl sulfate or sodium oleyl sulfate.

Examples of cationic surfactant include monoalkylamine salt, dialkylamine salt, trialkylamine salt, dimethyldialkylammonium salt, trimethylalkylammonium salt, dodecyltrimethylammonium salt, hexadecyltrimethylammonium salt, octadecyltrimethylammonium salt, dodecyldimethylammonium salt, octadecenyl dimethylethylammonium salt, dodecyldimethylbenzylammonium salt, hexadecyldimethylbenzylammonium salt, octadecyldimethylbenzylammonium salt, trimethylbenzylammonium salt, triethylbenzylammonium salt, hexadecylpyridinium salt, dodecylpyridinium salt, dodecylpicolinium salt, dodecylimidazolinium salt, oleyl imidazolinium salt, octadecylamine acetate, and dodecylamine acetate.

Examples of the nonionic surfactant include sugar ester, fatty acid ester, C₁ to C₂₅ alkoxyl phosphoric acid (salt), sorbitan ester, silicon-based polyoxyethylene ether, silicon-based polyoxyethylene ester, fluorine-based polyoxyethylene ether, fluorine-based polyoxyethylene ester, a sulfated or sulfonated adduct of a condensation product of ethylene oxide and/or propylene oxide and an alkylamine or diamine, and polyoxyethylene cumyl phenyl ether (however, EO chain is 10 to 14).

Examples of the amphoteric surfactant include betaine, carboxybetaine, imidazolinium betaine, sulfobetaine, and aminocarboxylic acid.

The antioxidant is used for preventing the oxidation of the soluble stannous salt to the stannic salt.

Examples of antioxidant include hypophosphorous acids, ascorbic acid or a salt thereof, phenolsulfonic acid (Na), cresolsulfonic acid (Na), hydroquinonesulfonic acid (Na), hydroquinone, α- or β-naphthol, catechol, resorcin, phloroglucin, hydrazine, phenolsulfonic acid, catecholsulfonic acid, hydroxybenzenesulfonic acid, naphtholsulfonic acid, and salts thereof.

The alcohol having 1 to 3 carbon atoms is used for improving the solubility of the surfactant. Examples of the alcohol include methanol, ethanol, 1-propanol, and 2-propanol. One of the alcohols can be used alone or a combination of two or more thereof can be used.

In a case where either one of the nonionic surfactant (C1 or C2) of the present embodiment is used alone, the amount of the nonionic surfactant (C1 or C2) in the plating liquid is 0.5 g/L to 50 g/L, and preferably 1 g/L to 5 g/L. In a case where the amount is less than the lower limit, plating failure such as a dendrite occurs due to an excessive supply of Sn ions. In addition, in a case where the amount exceeds the upper limit, Sn ions hardly reach a surface to be plated, and the via filling property may deteriorate. In a case where both the nonionic surfactant (C1) and the nonionic surfactant (C2) are used, the total amount of the nonionic surfactant (C1) and the amount of the nonionic surfactant (C2) may be set to be in the above-described range.

In addition, as the soluble metal salt (A), one of the compounds can be used alone or a combination of two or more thereof can be used, and an amount in the plating liquid is 30 g/L to 100 g/L, and preferably 40 g/L to 60 g/L. In a case where the amount is less than the appropriate range, the productivity is reduced, and in a case where the amount increases, the cost of the plating liquid increases.

As the inorganic acid, the organic acid, or the salt thereof (B), only one kind or two or more kinds of the compounds can be used, and an amount thereof in the plating liquid is 80 to 300 g/L, and preferably 100 to 200 g/L. In a case where the amount is less than the appropriate range, conductivity is low and voltage rises. In a case where the amount is more than the appropriate range, viscosity of the plating liquid increases and stirring speed of the plating liquid decreases.

The amount of the additive (E) in the plating liquid is 0.5 g/L to 50 g/L and preferably 1 g/L to 5 g/L.

Meanwhile, the temperature of the electroplating liquid of the present embodiment is generally 70°C or lower, and preferably 10°C to 40°C. The current density during the formation of a plated film by electroplating is in a range of 0.1 A/dm² to 100 A/dm² and preferably in a range of 0.5 A/dm² to 20 A/dm². In a case where the current density is excessively low, the productivity deteriorates, and in a case where the current density is excessively high, the height uniformity of the bumps deteriorates.

When the tin or tin-alloy plating liquid of the present embodiment containing the nonionic surfactant (C1 and/or C2) alone or both of the nonionic surfactant (C1) and the nonionic surfactant (C2) as the surfactant is applied to a circuit board serving as an object to be plated, and the liquid temperature and the current density are set to be within the ranges, a predetermined metal film (tin or tin-alloy plating deposition layer) can be formed on the circuit board. Then, when a reflow process is performed, bumps are formed.

When mounting the semiconductor chips on the bumps formed as described above, a circuit board on which the semiconductor chips are mounted is produced.

Examples of the circuit board include a printed circuit board, a flexible printed circuit board, and a semiconductor integrated circuit board.

### EXAMPLES

Next, examples of the present invention will be described in detail together with comparative examples.

### (Nonionic surfactant (C1) used in Examples and Comparative Examples)

Table 1 shows the carbon number of R, the number m of the polyoxyethylene (EO) group, and the number n of the polyoxypropylene (PO) group in each Structural Formula (1) of condensates of polyoxyethylene and polyoxypropylene alkyl ether or polyoxyethylene alkyl ethers (C1-1 to C1-17) which are nonionic surfactants (C1) used in Examples 1 to 8, 13, and 14 and Comparative Examples 1 to 10.

### (Nonionic surfactant (C2) used in Examples and Comparative Examples)

Table 2 shows the carbon number of R, the number m of the polyoxyethylene (EO) group, and the number n of the polyoxypropylene (PO) group in each Structural Formula (1) of condensates of polyoxypropylene and polyoxyethylene alkyl ether which are nonionic surfactants (C2) used in Examples 1, 2, and 9 to 14, and Comparative Examples 11 to 16 (C2-1 to C2-10). The number of carbon atoms in R and m and n values were determined by ¹H-NMR.

**Table 1**

| Nonionic surfactant compound (C1) No. | Structural formula of nonionic surfactant compound (C1) | | | Compound (C1) |
|---|---|---|---|---|
| | Carbon number of R | m (EO group) number | n (PO group) number | Mass average molecular weight |
| C1-1 | 7 | 2 | 0 | 270 |
| C1-2 | 16 | 3 | 0 | 350 |
| C1-3 | 7 | 4 | 0 | 430 |
| C1-4 | 6 | 5 | 0 | 380 |
| C1-5 | 7 | 5 | 0 | 350 |
| C1-6 | 13 | 6 | 0 | 500 |
| C1-7 | 13 | 7 | 0 | 520 |
| C1-8 | 7 | 11 | 1 | 750 |
| C1-9 | 9 | 6 | 2 | 530 |
| C1-10 | 13 | 8 | 2 | 650 |
| C1-11 | 9 | 8 | 3 | 700 |
| C1-12 | 16 | 10 | 3 | 890 |
| C1-13 | 8 | 13 | 3 | 930 |
| C1-14 | 16 | 15 | 3 | 1200 |
| C1-15 | 8 | 15 | 4 | 1100 |
| C1-16 | 16 | 8 | 4 | 850 |
| C1-17 | 9 | 8 | 4 | 750 |

**Table 2**

| Nonionic surfactant compound (C2) No. | Structural formula of nonionic surfactant compound (C2) | | | Compound (C2) |
|---|---|---|---|---|
| | Carbon number of R | m (EO group) number | n (PO group) number | Mass average molecular weight |
| C2-1 | 7 | 11 | 1 | 750 |
| C2-2 | 9 | 6 | 2 | 530 |
| C2-3 | 13 | 8 | 2 | 650 |
| C2-4 | 9 | 8 | 3 | 700 |
| C2-5 | 16 | 10 | 3 | 890 |
| C2-6 | 8 | 13 | 3 | 930 |
| C2-7 | 16 | 15 | 3 | 1200 |
| C2-8 | 8 | 15 | 4 | 1100 |
| C2-9 | 16 | 8 | 4 | 850 |
| C2-10 | 9 | 8 | 4 | 750 |

### (Initial make-up of Sn plating liquid)

### <Example 1>

Methanesulfonic acid as a free acid, hydroquinone as an antioxidant, 1-naphthaldehyde as a leveling agent (D-1), methacrylic acid as a leveling agent (D-2) were mixed with a Sn methanesulfonate aqueous solution to obtain a homogeneous solution. Then, as a surfactant, the above No. C1-6 polyoxyethylene alkyl ether (mass average molecular weight: 500, carbon number in R in Formula (1): 13, number m of polyoxyethylene (EO) groups: 6, and number n of polyoxypropylene (PO) groups: 0), the above No. C2-2 condensate of polyoxyethylene and polyoxypropylene alkyl ether (mass average molecular weight: 530, carbon number in R in Formula (2): 9, number m of polyoxyethylene (EO) groups: 6, and number n of polyoxypropylene (PO) groups: 2) were added. Ion-exchanged water was finally added to initially make-up a Sn plating liquid having the following composition. The Sn methanesulfonate aqueous solution was prepared by electrolyzing a metal Sn plate in a methanesulfonic acid aqueous solution.

### (Composition of Sn plating liquid)

Sn methanesulfonate (as Sn²⁺): 50 g/L
Potassium methanesulfonate (as free acid): 100 g/L
Nonionic surfactant CI-6: 2 g/L
Nonionic surfactant C2-2: 2 g/L
Hydroquinone (as the antioxidant): 1 g/L
1-naphthaldehyde (as the leveling agent (D-1)): 0.1 g/L
Methacrylic acid (as the leveling agent (D-2)): 2 g/L
Ion-exchanged water: remainder

### <Examples 3 to 5, 7 to 9, 11, 12, and 14 and Comparative Examples 1, 2, 4, 5, 7, 9, 10, 12, 13, 15, 16>

In Examples 3 to 5, 7 to 9, 11, 12, and 14 and Comparative Examples 1, 2, 4, 5, 7, 9, 10, 12, 13, 15, and 16, as the nonionic surfactant (C1) and the nonionic surfactant (C2), the surfactants having the properties shown in Tables 1 and 2 were used and selected as shown in Tables 3 and 4. Except for this, in the same manner as in Example 1, Sn plating liquids of Examples 3 to 5, 7 to 9, 11, 12, and 14 and Comparative Examples 1, 2, 4, 5, 7, 9, 10, 12, 13, 15, and 16 were initially made-up.

### (Initial make-up of SnAg plating liquid)

### <Example 2>

Methanesulfonic acid as a free acid, catechol as an antioxidant, benzaldehyde as the leveling agent (D-1), methyl methacrylic acid as the leveling agent (D-2) were mixed with the Sn methanesulfonate aqueous solution to dissolve. Further, an Ag methanesulfonate liquid was added and mixed. A homogeneous solution was obtained by mixing. Then, as a surfactant, the above No. C1-6 condensate of polyoxyethylene and polyoxypropylene alkyl ether (mass average molecular weight: 500, carbon number in R in Formula (1): 13, number m of polyoxyethylene (EO) groups: 6, and number n of polyoxypropylene (PO) groups: 0), the above No. C2-3 condensate of polyoxyethylene and polyoxypropylene alkyl ether (mass average molecular weight: 650, carbon number in R in Formula (2): 13, number m of polyoxyethylene (EO) groups: 8, and number n of polyoxypropylene (PO) groups: 2) were added. Ion-exchanged water was finally added to initially make-up a SnAg plating liquid having the following composition. The Sn methanesulfonate aqueous solution was prepared by electrolyzing a Sn metal plate in a methanesulfonic acid aqueous solution, and the Ag methanesulfonate aqueous solution was prepared by electrolyzing the Ag metal plate in a methanesulfonic acid aqueous solution.

### (Composition of SnAg plating liquid)

Sn methanesulfonate (as Sn²⁺): 60 g/L
Ag methanesulfonate (as Ag⁺): 1.0 g/L
Methanesulfonic acid (as free acid): 120 g/L
Nonionic surfactant C1-6: 1 g/L
Nonionic surfactant C2-3: 1 g/L
Catechol (as antioxidant): 1 g/L
Benzaldehyde (as leveling agent (D-1)): 0.05 g/L
Methyl methacrylic acid (as leveling agent (D-2)): 3 g/L
Ion-exchanged water: remainder

### <Examples 6 and 13 and Comparative Examples 3, 8, and 11>

In Examples 6 and 13 and Comparative Examples 3, 8, and 11, as the nonionic surfactant (C1) and the nonionic surfactant (C2), the surfactants having the properties shown in Tables 1 and 2 were used and selected as shown in Tables 3 and 4. Except for this, in the same manner as in Example 2, SnAg plating liquids of Examples 6 and 13 and Comparative Examples 3, 8, and 11 were initially made-up.

### (Initial make-up of SnCu plating liquid)

### <Example 10>

Methanesulfonic acid as a free acid, potassium hydroquinone sulfonate as an antioxidant, benzaldehyde as the leveling agent (D-1), methyl methacrylic acid as the leveling agent (D-2) were mixed with the Sn methanesulfonate aqueous solution to dissolve. Next, Cu methanesulfonate liquid was further added and mixed. A homogeneous solution was obtained by mixing. Next, as a surfactant, the No. C2-4 condensate of polyoxyethylene and polyoxypropylene (mass average molecular weight: 700, carbon number of R in Formula (2): 9, number m of polyoxyethylene (EO) groups: 8, number n of polyoxypropylene (PO) groups: 3) was added. Ion-exchanged water was finally added to initially make-up a SnCu plating liquid having the following composition. The Sn methanesulfonate aqueous solution was prepared by electrolyzing a Sn metal plate in a methanesulfonic acid aqueous solution, and the Cu methanesulfonate aqueous solution was prepared by electrolyzing the Cu metal plate in a methanesulfonic acid aqueous solution.

### (Composition of SnCu plating liquid)

Sn methanesulfonate (as Sn²⁺): 80 g/L
Cu methanesulfonate (as Cu²⁺): 0.5 g/L
Methanesulfonic acid (as free acid): 150 g/L
Nonionic surfactant C2-4: 5 g/L
Potassium hydroquinone sulfonate (as antioxidant): 1g/L
Benzaldehyde (as leveling agent (D-1)): 0.2 g/L
Methyl methacrylic acid (as leveling agent (D-2)): 5 g/L
Ion-exchanged water: remainder

### <Comparative Examples 6 and 14>

In Comparative Examples 6 and 14, as the surfactant, surfactants having the properties shown in Table 2 were used and selected as shown in Table 4. Except for this, in the same manner as in Example 10, SnCu plating liquids of Comparative Examples 6 and 14 were initially made-up.

### <Comparison Test and Evaluation>

Using the 30 kinds of plating liquids made-up in Examples 1 to 14 and Comparative Examples 1 to 16, tin or tin-alloy plating deposition layers were formed in the vias. Then, a reflow process was performed to form bumps. The via filling properties of the tin or tin-alloy plating deposition layers in the vias until the bumps were formed, the appearances of the bumps after the bump formation, and the bump height variation (uniformity) were evaluated. Tables 3 and 4 show the results thereof.

### (1) Via filling property of tin or tin-alloy plating deposition layers in vias

The tin or tin-alloy plating deposition layers in the vias were observed with a laser microscope, and a difference in height between the highest point and the lowest point of the plating deposition layer was measured. A case where the difference in height exceeded 5 µm was determined to be "poor", a case where the difference in height was 5 µm or less was determined to be "good", and these are shown in the "via filling property" column of Tables 3 and 4.

### (2) Appearance of tin or tin-alloy plating deposition layers in vias

The tin or tin-alloy plating deposition layers in the vias were observed with a laser microscope, and a surface roughness Ra was measured. A case where the surface roughness Ra of the plating deposition layer exceeded 2 µm was determined to be "poor", a case where the surface roughness Ra was 2 µm or less was determined to be "good", and these are shown in the "appearance of plating deposition layer" column of Tables 3 and 4.

### (3) Variation in bump heights

The heights of the bumps on the substrate were measured using an automatic appearance inspection device. A variation in heights was calculated from the measured bump heights. A case where the height variation was 3 or less was determined to be "uniform", a case where the height variation exceeded 3 was determined to be "non-uniform", and the results are shown in the "bump height variation" column of Tables 3 and 4.

### (4) Ease of generation of voids

Bumps (2000 bumps in total) arranged at pitch intervals of 180 µm, 250 µm, and 360 µm and having diameters of 70 µm, 90 µm, and 120 µm were formed. Transmission X-ray images of these bumps were captured. The captured image was visually observed. A case where one or more voids having a size of 1 % or more of the size of the bump was observed was determined to be "NG", and a case where no voids were observed was determined to be "OK". The results thereof are shown in the "void" column of Tables 3 and 4.

**Table 3**

| | Nonionic surfactant compound (C1) | | | | Nonionic surfactant compound (C2) | | | | Metal other than Sn | Evaluation | | | |
|---|---|---|---|---|---|---|---|---|---|---|---|---|---|
| | | | | | | | | | | Via filling property | Appearance of plating deposition layer | Bump height variation | Void |
| | Compound No. | Carbon number of R | EO groups m | PO groups n | Compound No. | Carbon number of R | EO group m | PO group n | | | | | |
| Example 1 | C1-6 | 13 | 6 | 0 | C2-2 | 9 | 6 | 2 | - | Good | Good | 1.1 | OK |
| Example 2 | C1-6 | 13 | 6 | 0 | C2-3 | 13 | 8 | 2 | Ag | Good | Good | 1.1 | OK |
| Example 3 | C1-5 | 7 | 5 | 0 | - | - | - | - | - | Good | Good | 2.3 | OK |
| Example 4 | C1-8 | 7 | 11 | 1 | - | - | - | - | - | Good | Good | 1.7 | OK |
| Example 5 | C1-6 | 13 | 6 | 0 | - | - | - | - | - | Good | Good | 1.0 | OK |
| Example 6 | C1-10 | 13 | 8 | 2 | - | - | - | - | Ag | Good | Good | 1.2 | OK |
| Example 7 | C1-7 | 13 | 7 | 0 | - | - | - | - | - | Good | Good | 1.6 | OK |
| Example 8 | C1-11 | 9 | 8 | 3 | - | - | - | - | - | Good | Good | 1.7 | OK |
| Example 9 | - | - | - | - | C2-2 | 9 | 6 | 2 | - | Good | Good | 2.6 | OK |
| Example 10 | - | - | - | - | C2-4 | 9 | 8 | 3 | Cu | Good | Good | 1.5 | OK |
| Example 11 | - | - | - | - | C2-1 | 7 | 11 | 1 | - | Good | Good | 2.0 | OK |
| Example 12 | - | - | - | - | C2-3 | 13 | 8 | 2 | - | Good | Good | 1.3 | OK |
| Example 13 | C1-6 | 13 | 6 | 0 | C2-2 | 9 | 6 | 2 | Ag | Good | Good | 1.4 | OK |
| Example 14 | C1-7 | 13 | 7 | 0 | C2-3 | 13 | 8 | 2 | - | Good | Good | 2.2 | OK |

**Table 4**

| | Nonionic surfactant compound (C1) | | | | Nonionic surfactant compound (C2) | | | | Metal other than Sn | Evaluation | | | |
|---|---|---|---|---|---|---|---|---|---|---|---|---|---|
| | Compound No. | Carbon number of R | EO groups m | PO groups n | Compound No. | Carbon number of R | EO groups m | PO groups n | | Via filling property | Appearance of plating deposition layer | Bump height variation | Void |
| Comparative example 1 | C1-1 | 7 | 2 | 0 | - | - | - | - | - | Poor | Poor | 5.3 | NG |
| Comparative example 2 | C1-2 | 16 | 3 | 0 | - | - | - | - | - | Poor | Poor | 8.1 | NG |
| Comparative example 3 | C1-3 | 7 | 4 | 0 | - | - | - | - | Ag | Poor | Poor | 4.3 | OK |
| Comparative example 4 | C1-4 | 6 | 5 | 0 | - | - | - | - | - | Poor | Poor | 3.1 | NG |
| Comparative example 5 | C1-12 | 16 | 10 | 3 | - | - | - | - | - | Poor | Poor | 3.2 | OK |
| Comparative example 6 | C1-13 | 8 | 13 | 3 | - | - | - | - | Cu | Good | Poor | 4.5 | NG |
| Comparative example 7 | C1-14 | 16 | 15 | 3 | - | - | - | - | - | Poor | Poor | 6.7 | NG |
| Comparative example 8 | C1-15 | 8 | 15 | 4 | - | - | - | - | Ag | Poor | Poor | 8.4 | NG |
| Comparative example 9 | C1-16 | 16 | 8 | 4 | - | - | - | - | - | Poor | Poor | 11.4 | NG |
| Comparative example 10 | C1-17 | 9 | 8 | 4 | - | - | - | - | - | Poor | Poor | 9.7 | NG |
| Comparative example 11 | - | - | - | - | C2-5 | 16 | 10 | 3 | Ag | Poor | Poor | 4.1 | OK |
| Comparative example 12 | - | - | - | - | C2-6 | 8 | 13 | 3 | - | Good | Poor | 3.3 | NG |
| Comparative example 13 | - | - | - | - | C2-7 | 16 | 15 | 3 | - | Poor | Poor | 7.5 | NG |
| Comparative example 14 | - | - | - | - | C2-8 | 8 | 15 | 4 | Cu | Poor | Poor | 9.8 | NG |
| Comparative example 15 | - | - | - | - | C2-9 | 16 | 8 | 4 | - | Poor | Poor | 13.4 | NG |
| Comparative example 16 | - | - | - | - | C2-10 | 9 | 8 | 4 | - | Poor | Poor | 10.1 | NG |

As is clear from Table 4, in Comparative Example 1, the number m of the EO groups was 2 which was too small, and thus the appearance of the plating deposition layers was poor and the via filling property was also poor. Furthermore, the height variation of the bumps was 5.3 which was large, and the generation of voids was observed which was determined to be NG.

In Comparative Example 2, the carbon number of R was 16 which was too large and the number m of EO groups was 3 which was too small. Therefore, the via filling property was poor and the appearance of the plating deposition layers was also poor. Furthermore, the height variation of the bumps was 8.1 which was large, and the generation of voids was observed which was determined to be NG.

In Comparative Example 3, the number m of the EO groups was 4 which was too small, and thus the appearance of the plating deposition layers was poor and the via filling property was also poor. Further, no voids were found which was determined to be OK. However, the height variation of the bumps was 4.3 which was large.

In Comparative Example 4, the carbon number of R was 6 which was too small, and thus the appearance of the plating deposition layers was poor and the via filling property was also poor. Furthermore, the height variation of the bumps was 3.1 which was large, and the generation of voids was observed which was determined to be NG.

In Comparative Examples 5 and 11, the carbon numbers of R were 16 which were too large and thus the via filling properties in both were poor and the appearances of the plating deposition layers were also poor. Further, no voids were found in both which were determined to be OK. However, the height variations of the bumps were 3.2 and 4.1 which were large.

In Comparative Examples 6 and 12, the numbers m of EO groups were 13 which were too large, and thus the via filling properties in both were good, but the appearances of the plating deposition layers were poor. Furthermore, the height variations of the bumps were 4.5 and 3.3 which were large, and the generations of voids were observed in both which were determined to be NG.

In Comparative Examples 7 and 13, the carbon numbers of R were 16 which were too large and the numbers m of the EO groups were 15 which were too large, and thus the via filling properties in both were poor and the appearances of the plating deposition layers were also poor. Furthermore, the height variations of the bumps were 6.7 and 7.5 which were large, and voids were found in both which were determined to be NG.

In Comparative Examples 8 and 14, the numbers m of EO groups were 15 which were too large and the numbers n of PO groups were 4 which were too large, and thus the appearances of the plating deposition layers in both were poor and the via filling properties were also poor. Furthermore, the height variations of the bumps were 8.4 and 9.8 which were large, and voids were found in both which were determined to be NG.

In Comparative Examples 9 and 15, the carbon numbers of R were 16 which were too large and the numbers n of the PO groups were 4 which were too large, and thus the via filling properties were poor in both and the appearances of the plating deposition layers were also poor. Furthermore, the height variations of the bumps were 11.4 and 13.4 which were large, and voids were found in both which were determined to be NG.

In Comparative Examples 10 and 16, the numbers n of PO groups were 4 which were too large and thus the via filling properties in both were poor and the appearances of the plating deposition layers were also poor. Furthermore, the height variations of the bumps were 9.7 and 10.1 which were large, and voids were found in both which were determined to be NG.

On the other hand, in Examples 1 to 14, the carbon numbers of R were in the range of 7 to 13, the numbers m of EO groups were in the range of 5 to 11, and the numbers n of PO groups were 0 to 3, and thus via filling properties were all good and the appearances of the plating deposition layers were also good. Furthermore, the height variations of the bumps were in the range of 1.0 to 2.6 which were small, and no voids were observed in all which were determined to be OK.

### Industrial Applicability

The tin or tin-alloy plating liquid of the embodiment can be used for a circuit board such as a printed circuit board, a flexible printed circuit board, and a semiconductor integrated circuit.

### Explanation of Reference Signs

- 1: Substrate
- 2: Solder resist layer
- 3: Copper seed layer
- 4: Dry film resist layer
- 6: Via
- 7: Tin plating deposition layer (tin plated film)
- 8: Tin bump

## Claims

1. A tin or tin-alloy plating liquid comprising:
(A) a soluble salt including at least a stannous salt;
(B) an acid selected from an organic acid and an inorganic acid, or a salt thereof;
(C) a surfactant;
(D) a leveling agent; and
(E) an additive,
wherein the surfactant is a compound (C1) represented by Formula (1) and/or a compound (C2) represented by Formula (2), 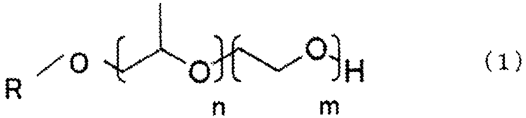 in Formula (1), R is an alkyl group having 7 to 13 carbon atoms, m is 5 to 11, n is 0 to 3, and m and n are different from each other, and 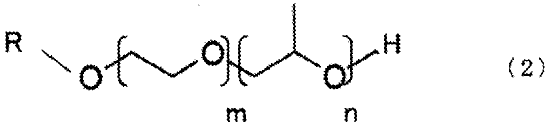 in Formula (2), R is an alkyl group having 7 to 13 carbon atoms, m is 5 to 11, n is 1 to 3, and m and n are different from each other.

2. The tin or tin-alloy plating liquid according to claim 1,
wherein the additive contains two or more selected from a surfactant other than the two surfactants (C1 and C2), an antioxidant, and an alcohol having 1 to 3 carbon atoms.

3. A method for forming bumps, the method comprising:
a step of forming tin or tin-alloy plating deposition layers on a substrate using the tin or tin-alloy plating liquid according to claim 1 or 2; and
a step of subsequently performing a reflow process to form bumps.

4. A method for producing a circuit board, the method comprising: producing a circuit board using the bumps formed by the method according to claim 3.
